# EUROPEAN PATENT APPLICATION

(11) **EP 1 586 946 A2**
(43) Date of publication of application: **19.10.2005**
(21) Application number: 05006179.5
(22) Date of filing: 22.03.2005
(51) Int. Cl.: G03F 7/20

(54) **Optical system of a microlithographic projection exposure apparatus**

(30) Priority: 14.04.2004 US 562060 P
(71) Applicant: Carl Zeiss SMT AG, 73447 Oberkochen (DE)
(72) Inventor: Maul, Manfred, 73434 Aalen (DE); Totzeck, Michael, 73535 Schwäbisch Gmünd (DE); Dittmann, Olaf, 73441 Bopfingen (DE); Fiolka, Damian, 73447 Oberkochen (DE)
(74) Representative: Schwanhäusser, Gernot

(57) **Abstract**

An optical system of a microlithographic projection exposure apparatus, which may for example be an illumination system or a projection objective (10), contains an optical element (L2, L3) which consists of a birefringent material. A projection light beam (14) formed by linearly polarized light rays passes through the optical element (L2, L3). In order to avoid perturbing the polarization distribution of the light beam, the material of which the optical element (L2, L3) consists is aligned so that each light ray entering the material is polarized substantially parallel or substantially perpendicularly to a birefringent axis, along which the refractive index of the material is greatest for the respective light ray.

## Description

The invention relates to an optical system of a microlithographic projection exposure apparatus according to the preamble of claim 1. The invention further relates to a method according to the preamble of claim 16.

The term optical birefringence refers to materials having an anisotropic refractive index. This means that for a light ray passing through the material, the refractive index depends on its polarization and its orientation with respect to the material. The term birefringence in the stricter sense refers to the maximum possible refractive index difference Δn of a birefringent material. Owing to the polarization-dependent refractive indices, an unpolarized light beam is generally split into two beam components with mutually orthogonal linear polarizations when it enters a birefringent material.

The birefringence of optical materials may have different causes. The term intrinsic birefringence is used for materials which have an anisotropic crystal structure. Uniaxial crystals such as calcspar are an example of this. Non-crystalline materials and materials with an isotropic crystal structure may be optically birefringent, too. In these cases, the birefringence is caused by perturbations of the short-range atomic order which, for example, may be due to externally acting mechanical forces, electric fields or magnetic fields. Often, the material loses its birefringence when the causes of the short-range order perturbations cease. For example, if a lens mounting exerts mechanical forces on a lens body received therein, these forces lead to stress-induced birefringence, and this birefringence generally vanishes as soon as the lens mounting is removed again.

If the stresses due to external forces remain in the material, then this can lead to permanent stress-induced birefringence. Quartz glass blanks, which are used for the production of lenses and other refractive optical elements, may display permanent stress-induced birefringence. This birefringence is generally a result of the production method and usually shows an at least approximately rotationally symmetrical dependence of the magnitude and orientation of the birefringence on the location where a light ray impinges on the material. In this case, the magnitude of the birefringence usually increases for growing distances from the centre of the optical element. In contrast to the birefringence of CaF₂ and similar crystals, this kind of stress induced birefringence is usually independent on the ray direction.

If this kind of birefringence cannot be tolerated, one may simply use blanks whose permanent stress-induced birefringence is very small. Such blanks, however, are usually quite expensive.

The problem of birefringence has gained particular importance in microlithographic projection exposure apparatuses which are designed for wavelengths in the deep ultraviolet spectral range (DUV), for instance 193 nm or 157 nm. Such systems are used for the lithographic production of large-scale integrated electrical circuits and other microstructured components. To this end, projection light from an illumination system is directed at a mask which contains a pattern of structures to be produced. With the aid of a projection objective, the mask is imaged onto a photosensitive layer. This layer is placed on a support, which is generally a silicon wafer.

In such projection exposure apparatuses, owing to the low transparency of conventional lens materials for DUV projection light, fluorspar (CaF₂) or another cubic crystalline material, for example BaF₂ or Ca₁₋ₓBaₓF₂, is now being used to a varying degree.

These crystals are sufficiently transparent even for DUV projection light. As it has been found, however, they are intrinsically birefringent for these wavelengths. If birefringence occurs in a projection objective, unless suitable countermeasures are taken, then this will lead to intolerable contrast losses in the image plane where the photosensitive layer is arranged.

The birefringence has a particularly unfavourable effect when the projection light is intended to arrive at the photosensitive layer with an accurately defined polarization. This is because the birefringence generally destroys any previously set polarization state to a greater or lesser extent. For example, linearly polarized projection light may be transformed into elliptically polarized projection light when it passes through a birefringent material.

In order to reduce the intrinsic birefringence in CaF₂ and similar cubic crystals as much as possible, it has been proposed to select the crystal orientations of a plurality of crystals in order to obtain an at least approximately rotationally symmetrical direction distributions of the birefringence, or even so that the retardances caused by the birefringent crystals substantially compensate each another. Such arrangements are described, for example, in WO 02/093209 A2.

However, complete compensation for the birefringence is generally not possible even with an optimum selection of the crystal orientations. This is due to the fact, inter alia, that complete compensation for the retardances due to the birefringence requires not only a corresponding direction distribution and magnitude of the birefringence as a material property, but also that particular criteria be satisfied for the geometrical path lengths travelled by the light rays in the crystals and the angles thereof with respect to the optical axis. A disadvantage of a complete compensation is furthermore that large numbers of very expensive CaF₂ crystals are often necessary, for example with [100] crystal axes being aligned parallel to the optical axis.

It is therefore an object of the invention to provide an optical system of a microlithographic projection exposure apparatus so that unfavourable effects of intrinsic or induced birefringence on a linear polarization state of transmitted projection light can be reduced in a straightforward way.

This object is achieved by an optical system according to claim 1 and by a method according to claim 16.

The invention is based on the idea that it is not always necessary to compensate for the birefringent effect of optical elements contained in the optical system. Often it is only important to ensure that the polarization distribution of a projection light beam is perturbed as little as possible. According to the invention, this can be achieved simply by suitably aligning the birefringent material with respect to the polarization distribution.

This aligning should be carried out so that - possibly for all light rays passing through the material - their polarization direction is aligned parallel or perpendicularly to a distinguished direction of the birefringence, i.e. the fast or slow axis. Such an alignment ensures that none of the light rays have different polarization components with unequal propagation velocities in the material. This prevents undesirable perturbations of the polarization distribution as they occur with arbitrary alignments.

Nevertheless, the alignment according to the invention does not necessarily mean that all light rays propagate with the same velocity in the material. This, however, is not actually necessary in order to preserve the polarization distribution as such.

For the alignment of the material, account may be taken of the fact that the light rays often pass only through a subvolume of the birefringent material, or a plurality of fairly small subvolumes. For example, in optical elements of an illumination system that are positioned close to a pupil plane, only an annular region or a plurality of individual separated regions (poles) may be traversed by projection light. For the alignment of the material, it is then sufficient to consider its birefringent axis only at those regions where projection light actually passes through the material. This may be important particularly for stress-induced birefringence, since this kind of birefringence depends not on the direction of the light rays but only on the location where the light ray strikes the material. For intrinsically birefringent materials, however, the birefringence is generally independent of this location so that any restriction to subvolumes through which projection light actually passes does not generally lead to fundamentally different results.

It is preferable for the light rays entering the material to be polarized as exactly as possible parallel or perpendicularly to the slow axis of the material. Minor deviations do not, however, substantially degrade the polarization state. With an alignment of the slow birefringent axis parallel to the polarization direction of the respective light ray, the perturbing effect due to the birefringent material is negligible if each light ray entering the material has a polarization direction which deviates from the respective birefringent axis by a value of no more than 15°, preferably no more than 5°.

If however the material is aligned so that for each light ray entering the material, its polarization direction is oriented substantially perpendicularly to the respective slow birefringent axis, then the perturbation remains negligibly small if each light ray entering the material has a polarization direction which deviates from the respective birefringent axis by a value of more than 75° but less than 105°, preferably more than 85° but less than 95°.

The polarization distribution in the polarization light beam may, for example, be arranged so that the oscillation planes of all light rays entering the optical element are at least substantially parallel to one another. With such a linear homogeneous polarization, the material should then be aligned so that, for all light rays, the slow birefringent axis is also parallel or perpendicular to the polarization direction.

This may for example be achieved with cubic crystalline materials, for example CaF₂ or BaF₂ or Ca₁₋ₓBaₓF₂, which are aligned so that the [110] crystal axis is oriented along an optical axis of the system. Especially in the case of aperture angles which are small, for example less than 40°, preferably less than 20° and more preferably less than 10°, the birefringence distribution in the case of such crystal orientations is linear and homogeneous to a good approximation.

A tangential or radial polarization is often desirable in projection exposure apparatuses. With a tangential polarization, the oscillation planes of all light rays entering the optical element are at least substantially perpendicular to a plane which is defined by an optical axis of the optical system and the propagation direction of the respective light ray. With a radial polarization, the oscillation planes extend perpendicularly to this, i.e. substantially parallel to the said plane.

In order to reduce the perturbing effect of the birefringence on the polarization distribution in these cases, a cubic crystal may be used as the material for the optical element, in particular CaF₂ or BaF₂ or Ca₁₋ₓBaₓF₂, which is aligned so that the [100] crystal axis extends substantially parallel to the optical axis. Although the birefringence distribution is not rotationally symmetrical with this crystal orientation, it is nevertheless tangential to a good approximation so that the slow birefringent axes are oriented parallel to the polarization direction of the individual light rays.

A radial or tangential, but not necessarily rotationally symmetrical, birefringence distribution can also be achieved if the optical element comprises at least two subelements which respectively consist of a cubic crystal, wherein the crystals of the at least two subelements are aligned so that their overall birefringence direction distribution is substantially radial or tangential with respect to the optical axis of the optical system.

One way of achieving a rotationally symmetrical tangential birefringence distribution is to select two subelements made of crystals whose lattices are aligned so that the [100] crystal axes extend substantially parallel to the optical axis and are mutually rotated by 45° or an odd multiple thereof with respect to the optical axis. In the resulting birefringence distribution the slow birefringent axis extends tangentially and rotationally symmetrically with respect to the optical axis.

One way of achieving a rotationally symmetrical birefringence distribution with a radially extending slow axis is to form the optical element using two subelements having crystal lattices which are aligned so that the [111] crystal axes extend substantially parallel to the optical axis and are mutually rotated by 60° or an odd multiple thereof with respect to the optical axis. Expensive CaF₂ crystals with [100] crystal axes oriented along the optical axis may then dispensed with.

Many optical elements consist of a material, for example quartz glass, which does not have intrinsic birefringence but displays permanent stress-induced birefringence instead. If such a material is aligned so that an existing direction distribution of the birefringence is oriented substantially radially or tangentially with respect to the optical axis of the optical system, then such a stress-induced birefringent optical element will not (substantially) perturb a tangential or radial polarization distribution.

Various features and advantages of the present invention may be more readily understood with reference to the following detailed description taken in conjunction with the accompanying drawing in which:
- FIG. 1: shows a meridional section through a microlithographic projection exposure apparatus in a highly schematic representation;
- FIG. 2: shows a tangential polarization distribution of the projection light before a lens L2;
- FIG. 3: shows a detail of FIG. 1, in which two lenses L2 and L3 made of CaF₂ crystals are illustrated on an enlarged scale with the crystal orientations being indicated;
- FIG. 4: shows a diagram to explain the terms aperture angle and azimuth angle;
- FIG. 5: shows a birefringence distribution which is produced by the combination of the two lenses L2 and L3 shown in FIG. 3;
- FIG. 6: shows a birefringence distribution such as may be produced by lenses with differently aligned crystal structures or, similarly, by stress-induced birefringent quartz glass;
- FIG. 7: shows a homogeneous linear polarization distribution of the projection light before the lens L2;
- FIG. 8: shows a birefringence distribution which is respectively produced by the two lenses L2 and L3 with differently aligned crystal structures.

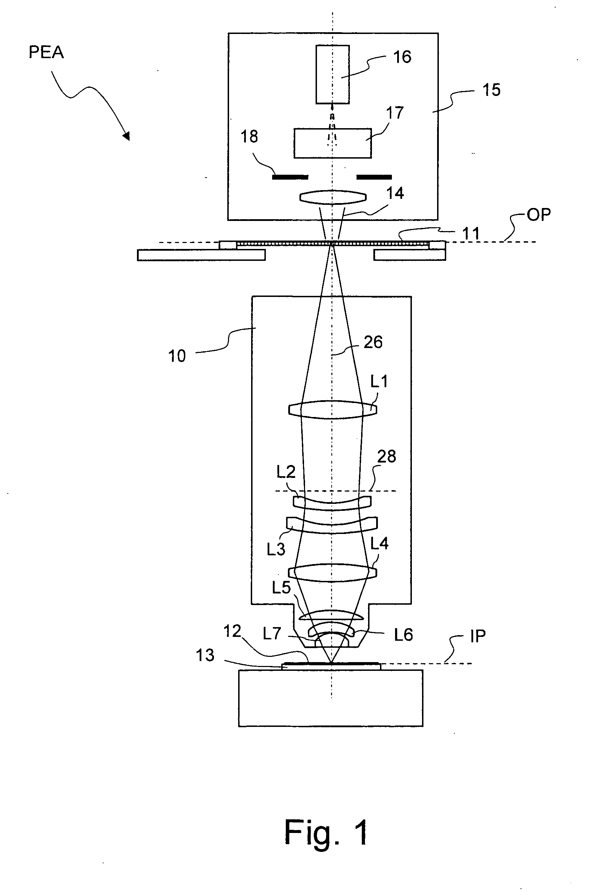

FIG. 1 shows a meridional section through a microlithographic projection exposure apparatus, denoted in its entirety by PEA, in a highly schematic representation. The projection exposure apparatus PEA comprises an illumination system 15 for producing a projection light beam 14. In the exemplary embodiment shown, the wavelength of the projection light is λ = 193 nm. The illumination system 15 contains a light source 16, illumination optics indicated by 17 and a diaphragm 18. The illumination optics 17 makes it possible to set different illumination angle distributions. To this end the illumination system may contain interchangeable diffractive optical elements or microlens arrays, for example. The illumination optics 17 may furthermore contain axicon elements which are arranged so that they can be moved along an optical axis 26. Since such illumination optics are known in the prior art, see for example US 6 285 443 A, whose full disclosure is incorporated herein by reference, further details need not be explained here.

The projection exposure apparatus PEA furthermore includes a projection objective 10 which contains a plurality of lenses. In FIG. 1 only some lenses are denoted by reference numerals L1 to L7 for the sake of clarity. The projection objective 10 is used to project a reduced image of a mask 11, which can be arranged in an object plane OP of the projection objective 10, onto a photosensitive layer 12 which may be a photoresist applied to a wafer 13, for example, and which is arranged in an image plane IP of the projection objective 10.

It will be assumed below that the projection light beam 14 produced by the illumination system 15 is tangentially polarized. In a tangential polarization, each light ray of the projection light beam 14 is linearly polarized with a polarization direction that extends perpendicularly to a plane which is defined by the optical axis 26 and the propagation direction of the respective light ray. The term polarization direction refers to the direction in which the electric field vector oscillates. Together with the propagation direction, this vector in turn defines the oscillation plane of the respective light ray.

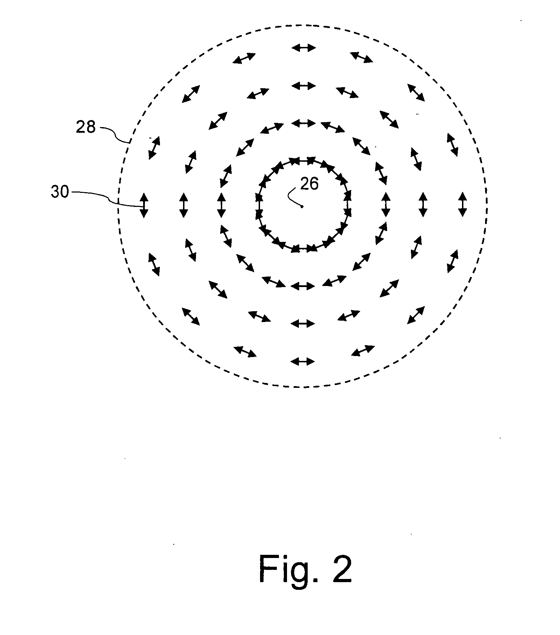

FIG. 2 shows a schematic representation of the tangential polarization distribution of the projection light beam 14 in an imaginary plane 28, which lies immediately in front of the lens L2 and extends perpendicularly to the optical axis 26. It can be seen therein that the polarization directions (indicated by double arrows 30) of the light beams extend tangentially with respect to the optical axis 26.

Such a tangential polarization is particularly advantageous because the light rays forming the projection light beam 14 are polarized perpendicularly (s-polarization) to the plane of incidence when they strike the photosensitive layer 12. The desired interference phenomena on the photosensitive layer 12 are therefore independent of the angle at which the various diffraction orders strike the photosensitive layer 12. With projection light polarized parallel to the incidence plane (p-polarization), however, differing diffraction orders can no longer completely interfere since they have different polarization directions.

The production of a tangential polarization is known as such in the art. For example, it is possible to use polarization-rotating devices such as those described in US 2002/0126380 A. This known device produces radially polarized light. This can be easily converted into tangentially polarized light by rotating the polarization direction through 90° in two suitably oriented half-wave plates. Such devices for producing a tangential polarization may be arranged in the illumination system 15, as mentioned, or they may alternatively be arranged at other positions within the projection exposure apparatus.

In order to preserve the tangential polarization (as shown in FIG. 2) of the projection light beam 14 when it passes through the projection objective 10, the latter should not contain any optical elements which significantly change the polarization state of the light rays. Such changes may, for example, be caused by birefringent optical elements.

It will be assumed below that the lenses L2 and L3 of the projection objective 10 are both made of a calcium fluoride (CaF₂) crystal. These crystals have the property of being intrinsically birefringent for very short-wave UV light and thus also for the projection light of the present embodiment having a wavelength of 193 nm.

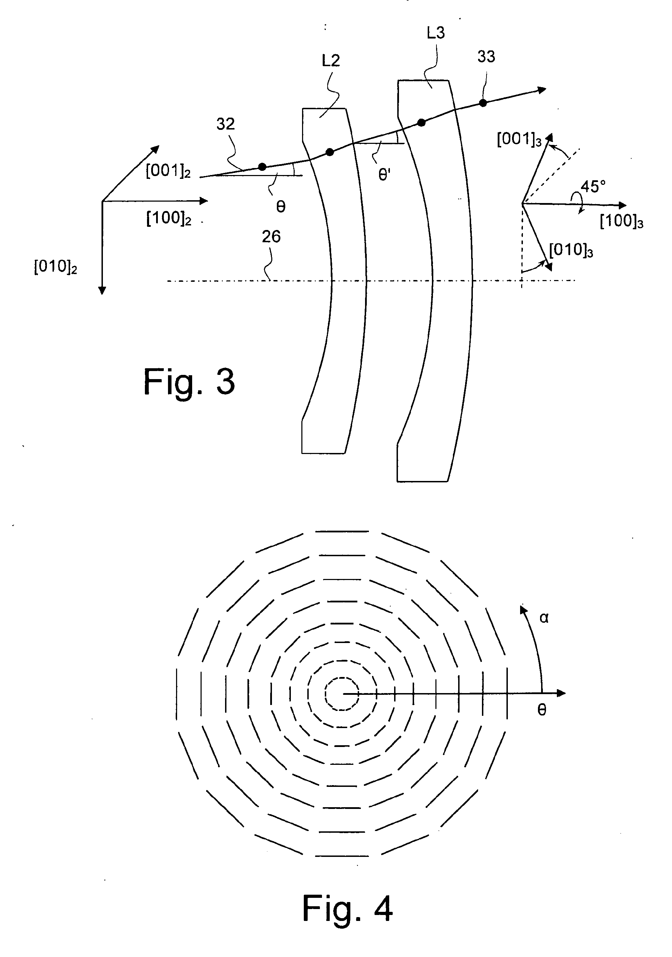

FIG. 3 shows the two lenses L2 and L3 in an enlarged representation, where the orientations of the crystal lattices are indicated by tripods. The calcium fluoride crystals, of which the lenses L2 and L3 are made, are aligned with respect to the optical axis 26 so that their [100] crystal axes, which are denoted by [100]₂ and [100]₃, respectively, are both aligned parallel to the optical axis 26 of the projection objective 10. Furthermore, the crystal lattices are mutually rotated by approximately 45° about the [100] crystal axis, as indicated by arrows in FIG. 3.

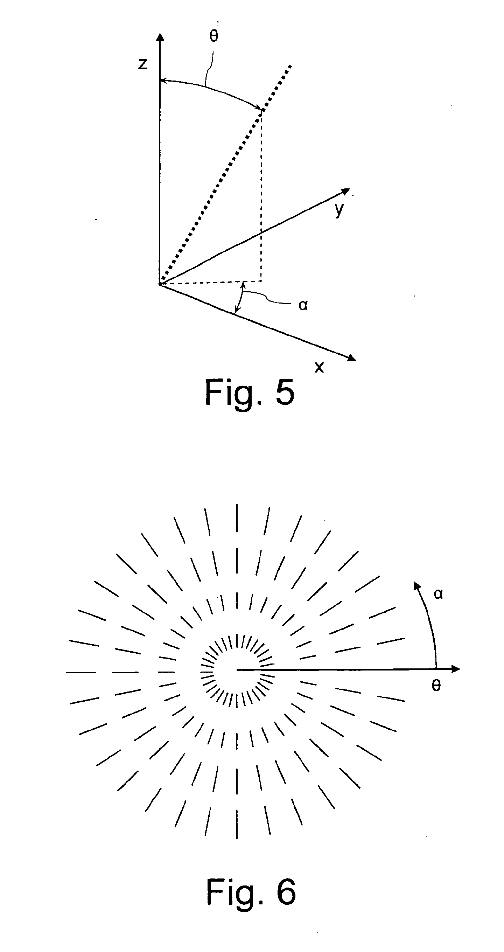

As described in more detail in WO 02/093209 that has already been mentioned before, such an arrangement of the crystal lattices leads to a rotationally symmetrical birefringence distribution, as is shown in FIG. 4. Each line in FIG. 4 represents the magnitude and the direction for a ray direction, defined by the aperture angle θ and the azimuth angle α, with which a light ray strikes the lens L2. As shown in FIG. 5, the aperture angle θ refers to the angle between the z axis, which coincides with the optical axis 26, and the ray direction. The azimuth angle α is the angle formed between a projection of the light ray onto the x-y plane and the x axis as a reference direction.

The length of the lines shown in FIG. 4 is proportional to the magnitude Δn (θ, α) of the birefringence, i.e. the maximum possible refractive index difference. In geometrical terms, the length of the lines describes the difference in the principal axis lengths of an elliptical section through the refractive index ellipsoid, while the direction of the lines indicates the orientations of the longer principal axis of the elliptical section. The elliptical section is obtained by cutting the refractive index ellipsoid, for the relevant ray of direction (θ, α), with a plane which is perpendicular to the ray direction and contains the centre of the refractive index ellipsoid.

As shown by FIG. 4, the resulting birefringence distribution Δn (θ, α) is rotationally symmetrical with the alignment of the crystal lattices as shown in FIG. 3. The slow birefringent axes, i.e. the longer principal axes of the elliptical sections, along which the refractive index of the crystal is greatest for the light ray, extend tangentially.

The superposition of the individual birefringence distributions of the lenses L2 and L3 that forms an overall birefringence distribution as shown in FIG. 4, is, however, applicable only if (a) the light rays of the two lenses L2 and L3 are transmitted at the same angle and (b) travel the same geometrical path lengths. This condition is fulfilled for plane-parallel plates of equal thickness. For the lenses L2 and L3 shown in FIG. 3, however, this is still at least approximately the case since the two lenses have a relatively low refractive power.

If the projection light beam 14 with the tangential polarization schematically represented in FIG. 2 now strikes the lenses L2 and L3, then it is ensured for each light ray that its polarization direction is at least approximately parallel to the slow birefringent axis direction (indicated by lines of different length and orientation in FIG. 4) applicable to the respective light ray. The effect of this is that, for each light ray, both calcium fluoride crystals appear to consist of one material having a refractive index which is independent of the polarization, even though it is dependent on the angle. Thus undesirable perturbations of the polarization cannot occur, as would be the case if different polarization components of a light ray were to propagate with a different velocity in the crystal.

The fact that the refractive index is lower for smaller aperture angles θ than for larger aperture angles θ can be compensated for, for example, by using a transparent compensation element with a spherical or aspherical surface, which compensates for the deviations of the optical path due to the refractive index profile. Preferably, however, the modified refractive index profile is taken into account when establishing the shape of the birefringent or other lenses present in the system.

Although the birefringence distribution of each calcium fluoride crystal is not rotationally symmetrical if the [100] crystal axis is aligned along the optical axis, the slow birefringent axis does nevertheless approximately extend tangentially. Therefore the polarization direction of the incident tangentially polarized light rays are parallel to the slow birefringent axis in the crystals, even for each individual lens L2 and L3 taken on its own.

The polarization state of a light ray consequently remains unchanged not only when passing through the combination of the two lenses L2 and L3, but also when passing through each individual lens. This is represented in FIG. 3 for a light ray 32, where points 33 indicate a polarization direction extending perpendicularly to a plane which is defined by the propagation direction of the light ray 32 and the optical axis 26 (i.e. the plane of the paper in FIG. 3).

The combination of the two lenses L2 and L3 does, however, have the advantage that an overall rotationally symmetrical birefringence distribution is obtained. For the tangentially polarized projection light beam 14, without this combination, each individual one of the two lenses L2 and L3 would have a refractive index profile which depends with a fourfold symmetry on the aperture angle θ. The fourfold aspect results here from the fourfold nature of the birefringence distribution associated with each individual crystal taken on its own. Owing to the mutually rotated crystal orientations, the respective fourfold refractive index profiles overlap so as to provide an overall rotationally symmetrical refractive index profile, i.e. for the two lenses L2 and L3 taken together.

The tangential polarization of the projection light beam 14, however, remains unaffected even if the slow birefringent axes are aligned not parallel but perpendicularly to the polarization direction of the light rays.

This will be explained with reference to the birefringence distribution Δn (θ, α) shown in FIG. 6. Similar to FIG. 4, the direction of the lines in FIG. 6 indicates the direction of the slow birefringent axis which a light ray experiences when it strikes the birefringent crystal with the aperture angle θ and the azimuth angle α. In contrast to the case shown in FIG. 4, however, the slow birefringent axes extend not tangentially but radially with respect to the optical axis 26. The polarization directions of the tangentially polarized light rays in this case extend not parallel to the slow birefringent axis but parallel to the fast birefringent axis, which is always perpendicular to the slow birefringent axis. In this case as well, therefore, the individual light rays do not contain any polarization components which experience a different refractive index in the material and which can therefore contribute to a change of the polarization state.

The rotationally symmetrical radial birefringence distribution shown in FIG. 6 is obtained, for example, when two calcium fluoride crystals are combined with their [111] crystal axes aligned parallel to the optical axis 26, but are mutually rotated by 60° or an odd multiple thereof about the optical axis 26.

Approximately rotationally symmetrical radial distributions of the birefringence, such as those shown in FIG. 6, also often occur in materials which are not intrinsically birefringent but display permanent stress-induced birefringence instead. Quartz glass blanks used for lens production are an example of this. In these cases the birefringence is not dependent on the direction the impinging light rays, but on the location where the light ray impinges on the material. An at least approximately radial and rotationally symmetrical birefringence distribution is generally production-related and, once it has occurred, it may be compensated for in a similar way to the intrinsic birefringence in cubic crystalline materials. It is possible to resort to blanks whose stress-induced birefringence is very small, but such blanks are very expensive.

If a blank which does have permanent stress-induced birefringence is selected, but this birefringence has, at least to a good approximation, a rotationally symmetrical radial or tangential locally varying birefringence distribution, then such a blank can be used without perturbing the tangential polarization of the projection light beam 14. It is then merely necessary to ensure that the symmetry axis of the birefringence extends coaxially with the optical axis.

For the case in which the illumination system does not produce light with the tangential polarization distribution shown in FIG. 2, but light with a radial polarization distribution instead, then perturbation of the polarization state can be prevented by the same measures as those explained above. This is due to the fact that the polarization directions in a tangential polarization distribution and in a radial polarization distribution are mutually perpendicular. Consequently, whenever the polarization directions in the tangential polarization distribution are parallel to a slow birefringent axis, the polarization directions in the radial polarization distribution will be parallel to the fast birefringent axis. In both cases, the polarization state is not perturbed by the birefringence.

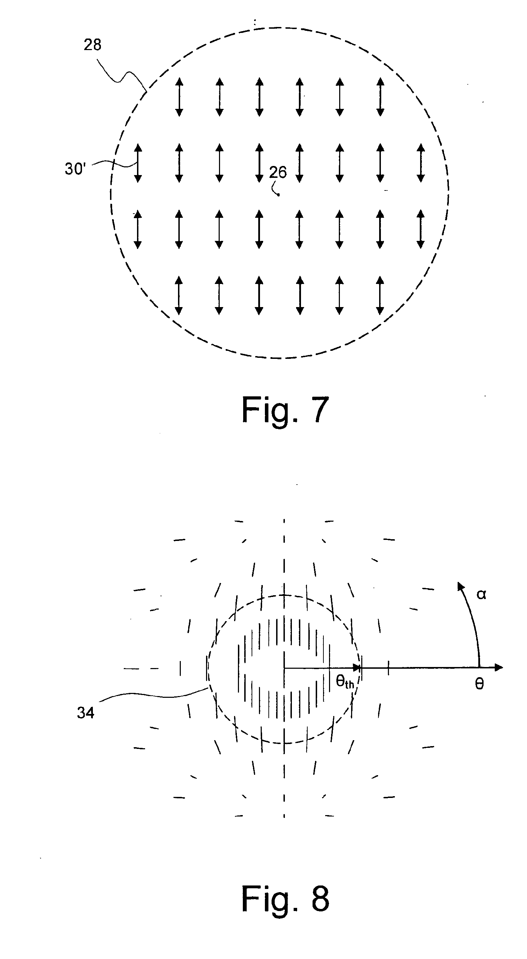

It will be assumed below that the polarization distribution prevailing in the plane 28 is not tangential but homogeneous. In this case, all light rays of the projection light beam 14 which pass through the plane 28 have the same polarization. This is indicated by double arrows 30' in FIG. 7.

In order to preserve this polarization distribution when passing through intrinsically birefringent materials, the latter should be aligned so that the polarization direction 30' extends parallel to the slow or fast birefringent axis.

FIG. 8 shows a birefringence distribution Δn' (θ, α) obtained with a calcium fluoride crystal whose [110] crystal axis is aligned along the optical axis 26. In this birefringence distribution Δn' (θ, α), it can be seen that the birefringence distribution is likewise homogeneous at least for smaller aperture angles θ in the sense that the direction of the slow birefringent axis is approximately the same for all light rays. In FIG. 8 a circle 34 with a radius corresponding to a threshold angle θₜₕ indicates a region in which the birefringence distribution is homogeneous to a good approximation.

For avoiding a perturbation of the homogeneous polarization distribution shown in FIG. 7 by an intrinsically birefringent crystal with the birefringence distribution shown in FIG. 8, it is merely necessary to ensure that the crystal is rotated about the optical axis 26 so that the slow birefringent axes are aligned either parallel or perpendicularly to the polarization direction of the projection light beam 14. To this end, for example, the optical element consisting of the crystal may be held in a mount which, with the aid of a rotating mechanism known as such, makes it possible to rotate the optical element about the optical axis 26.

It should be understood that the aforementioned alignment of birefringent optical elements with a predetermined polarization distribution can be used advantageously not only in a projection objective but also in an illumination system of a projection exposure apparatus. Furthermore, the invention is not restricted to the aforementioned polarization distributions in which the light rays are linearly polarized tangentially, radially or homogeneously.

Moreover, it is of course possible to use other cubic crystalline materials such as barium fluoride (BaF₂) instead of calcium fluoride. In barium fluoride, the slow birefringent axis and the fast birefringent axis are reversed in comparison with calcium fluoride, but this does not change the polarization of the transmitted projection light when the alignments described above are used.

## Claims

1. Optical system of a microlithographic projection exposure apparatus, in which a projection light beam (14) formed by linearly polarized light rays passes through an optical element (L2, L3) which consists of a birefringent material,
**characterised in that**
the material is aligned so that each light ray entering the material is linearly polarized substantially parallel or substantially perpendicularly to a birefringence axis, along which the refractive index of the material is greatest for the respective light ray.

2. Optical system according to Claim 1, **characterised**
**in that** each light ray entering the material has a polarization direction (30; 30') which deviates from the respective birefringent axis by a value of no more than 15°, preferably no more than 5°.

3. Optical system according to Claim 1, **characterised**
**in that** each light ray entering the material has a polarization direction (30; 30') which deviates from the respective birefringent axis by a value of more than 75° but less than 105°, preferably more than 85° but less than 95°.

4. Optical system according to one of the preceding
claims, **characterised in that** the oscillation planes of all light rays entering the optical element (L2, L3) are at least substantially parallel to one another.

5. Optical system according to Claim 4, **characterised**
**in that** the material is a cubic crystal, in particular CaF₂ or BaF₂ or Ca₁₋ₓBaₓF₂, and in that the crystal is aligned so that the [110] crystal axis is oriented along an optical axis (26) of the optical system (10).

6. Optical system according to Claim 5, **characterised**
**in that** the light rays entering the crystal form aperture angles with the optical axis (26) of less than 40°, preferably less than 20°, more preferably less than 10°.

7. Optical system according to one of Claims 1 to 3,
**characterised in that** the oscillation planes of all light rays entering the optical element (L2, L3) are at least substantially perpendicular or parallel to a plane which is defined by an optical axis (26) of the optical system (10) and the propagation direction of the respective light ray.

8. Optical system according to Claim 7, **characterised**
**in that** the material is a cubic crystal, in particular CaF₂ or BaF₂ or Ca₁₋ₓBaₓF₂, which is aligned so that the [100] crystal axis extends substantially parallel to the optical axis (26).

9. Optical system according to Claim 7, **characterised**
**in that** the optical element (L2, L3) comprises at least two subelements each consisting of a cubic crystal, in particular CaF₂ or BaF₂ or Ca₁₋ₓBaₓF₂, and in that the crystals of the at least two subelements are aligned so that their overall birefringence direction distribution is substantially radial or tangential with respect to the optical axis (26) of the optical system (10).

10. Optical system according to Claim 9, **characterised**
**in that** the crystals are aligned so that the direction distribution is at least substantially rotationally symmetrical.

11. Optical system according to Claim 10, **characterised**
**in that** the optical element comprises a first subelement (L2) and a second subelement (L3), made of crystals whose crystal lattices are aligned so that the [100] crystal axes extend substantially parallel to the optical axis (26) and are mutually rotated by 45° or an odd multiple thereof with respect to the optical axis (26) .

12. Optical system according to Claim 10, **characterised**
**in that** optical element comprises a first subelement and a second subelement, made of crystals whose crystal lattices are aligned so that the [111] crystal axes extend substantially parallel to the optical axis (26) and are mutually rotated by 60° or an odd multiple thereof with respect to the optical axis (26).

13. Optical system according to Claim 7, **characterised**
**in that** the optical element consists of a material which has stress-induced birefringence with a birefringence direction distribution which is substantially radial or tangential with respect to the optical axis (26) of the system (10).

14. Optical system according to one of the preceding
claims, **characterised in that** the system is an illumination system (15) for illuminating a mask (11) .

15. Optical system according to one of Claims 1 to 13,
**characterised in that** the system is a projection objective (10) for the imaging structures contained in a mask (11) onto a photosensitive layer (12).

16. Method for reducing perturbations, which a birefringent optical element (L2, L3) in a microlithographic projection exposure apparatus causes in a predetermined polarization distribution of a projection light beam (14),
**characterised in that**
the material of which the optical element (L2, L3) consists is aligned so that each light ray entering the material is linearly polarized substantially parallel or substantially perpendicularly to a birefringent axis, along which the refractive index of the material is greatest for the respective light ray.

17. Method according to Claim 16, **characterised in that**,
with the predetermined polarization distribution, the oscillation planes of all light rays entering the optical element are at least substantially perpendicular or parallel to a plane which is defined by an optical axis (26) of the projection exposure apparatus and the propagation direction of the respective light ray.

18. Method according to Claim 17, **characterised in that**
the material is a cubic crystal, in particular CaF₂ or BaF₂ or Ca₁₋ₓBaₓF₂, which is aligned so that the [100] crystal axis extends substantially parallel to the optical axis (26), and **in that** the crystal is rotated about the optical axis (26) in order to reduce the perturbations of the polarization distribution.

19. Method according to one of Claims 16 to 18, **characterised in that**, when determining the alignment of the material, the locations where the light rays pass through the material are taken into account.

20. Method according to Claim 19, **characterised in that** the material is stress-induced birefringent.

21. Method for the microlithographic production of
microstructured components, comprising the following steps:
a) providing a support (13) supporting a layer (12) of a photosensitive material;
b) providing a mask (11) containing structures to be imaged;
c) projecting at least a part of the mask (11) onto the layer (12) by using a projection exposure apparatus which contains an optical system (10) according to one of Claims 1 to 15.
